# EUROPEAN PATENT APPLICATION

(11) **EP 4 841 283 A2**
(43) Date of publication of application: **18.11.2026**
(21) Application number: 26169080.4
(22) Date of filing: 30.03.2026
(51) Int. Cl.: G01R 31/392, G01R 31/00, G01R 31/367, G01R 31/374

(54) **BATTERY MANAGEMENT SYSTEM AND DATA STRUCTURE FOR MANAGING BATTERIES**

(30) Priority: 13.05.2025 JP 2025080733
(71) Applicant: Toyota Jidosha Kabushiki Kaisha, Toyota-shi, Aichi-ken 471-8571 (JP)
(72) Inventor: YOKOYAMA, Daiki, Toyota-shi, 471-8571 (JP); YOKOYAMA, Kouichi, Toyota-shi, 471-8571 (JP)
(74) Representative: J A Kemp LLP

(57) **Abstract**

The battery management system (100) includes a primary use information acquisition unit (501) that acquires primary use information indicating a manner of use of a battery (61) during primary use of the battery (61), a secondary use information acquisition unit (502) that acquires secondary use information indicating a manner of use of the battery (62) during secondary use of the battery (62), and a model selection unit (506). The model selection unit (506) selects, from among a plurality of trained models (525) trained to estimate a battery parameter during the primary use, a model for estimating the battery parameter during the secondary use, based on the primary use information and the secondary use information.

## Description

### CROSS REFERENCE TO RELATED APPLICATIONS

This nonprovisional application is based on Japanese Patent Application No. 2025-080733 filed on May 13, 2025 with the Japan Patent Office, the entire contents of which are hereby incorporated by reference.

### BACKGROUND

### Field

The present disclosure relates to battery management systems and data structures for managing batteries.

### Description of the Background Art

In recent years, in order to reduce the environmental load, reuse of a battery mounted on a vehicle or the like has been required. Various techniques related to battery reuse have been proposed. A method of estimating a state of charge of a power storage device disclosed in WO2019/193471 includes: determining an electrical circuit model of the power storage device; optimizing the electrical circuit model of the power storage device such that an input is a current and an output is a voltage, and an output error of a voltage of the power storage device is reduced; calculating an initial parameter of the electrical circuit model of the power storage device; storing an initial parameter group corresponding to different input current values; determining an initial parameter value by neural network processing using the initial parameter group as training data; and estimating the charging rate by calculating the initial parameter by Kalman filter processing.

### SUMMARY

It has been proposed to use a trained model generated by machine learning, in order to estimate a battery parameter indicating a state of a battery (a parameter indicating a state of charge, a state of health, or the like).

It is conceivable to use the trained model also for secondary use, i.e., reuse of a battery after primary use of the battery. However, what kind of machine learning model should be used for secondary use of a battery has hardly been studied. It is desirable to be able to suitably provide a machine learning model (trained model) to be used for secondary use of a battery.

The present disclosure is made to solve the above-described problem, and one of objects of the present disclosure is to suitably provide a trained model to be used for secondary use of a battery.

A battery management system according to a first aspect of the present disclosure includes: a primary use information acquisition unit that acquires primary use information indicating a manner of use of a battery during primary use of the battery; a secondary use information acquisition unit that acquires secondary use information indicating a manner of use of the battery during secondary use of the battery; and a model selection unit. The model selection unit selects, from among a plurality of trained models trained to estimate a battery parameter indicating a state of the battery during the primary use, a trained model for estimating the battery parameter during the secondary use, based on the primary use information and the secondary use information.

A data structure according to a second aspect of the present disclosure is a data structure for managing a battery, and is used for a process of selecting, from among a plurality of trained models trained to estimate a battery parameter indicating a state of a battery during primary use of the battery, a trained model for estimating the battery parameter during secondary use of the battery. A type of the battery, primary use information indicating a manner of use of the battery during the primary use, secondary use information indicating a manner of use of the battery during the secondary use, and any model among the plurality of trained models are associated with each other.

It is also conceivable to newly generate a trained model to be used for secondary use of a battery. However, since this requires a large amount of learning data, it takes time to prepare required learning data. In contrast, according to the above-described configuration, a model for estimating a battery parameter during secondary use is selected from among a plurality of trained models trained to estimate the battery parameter during primary use, based on the primary use information and the secondary use information. Accordingly, the trained model to be used for secondary use of the battery can be provided at an early stage.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a block diagram illustrating an example of an overall configuration of a battery management system according to an embodiment of the present disclosure.
Fig. 2 is a block diagram illustrating an example of configurations of a battery management server and a second server.
Fig. 3 is a conceptual diagram for explaining selection of a trained model according to the present embodiment.
Fig. 4 is a diagram for explaining an example of classification of use patterns.
Fig. 5 is a diagram illustrating a use pattern table.
Fig. 6 is a diagram for explaining an example of transfer learning by a second server.
Fig. 7 is a diagram for explaining a specific example of transfer learning.
Fig. 8 is a flowchart illustrating an example of a processing procedure relating to acquisition of battery information and generation of primary use information during primary use of a battery.
Fig. 9 is a flowchart illustrating an example of a processing procedure relating to transmission and reception of primary use information.
Fig. 10 is a flowchart illustrating an example of a processing procedure relating to the start of secondary use of a battery.
Fig. 11 is a flowchart illustrating an example of a processing procedure relating to selection of a trained model.
Fig. 12 is a flowchart illustrating an example of a processing procedure relating to transfer learning of a trained model and inference using a learning model.
Fig. 13 is a flowchart illustrating an example of a processing procedure for a trained model according to a modification.

### DESCRIPTION OF THE PREFERRED EMBODIMENTS

Hereinafter, embodiments of the present disclosure will be described in detail with reference to the drawings. In the drawings, the same or corresponding parts are denoted by the same reference characters, and the description thereof will not be repeated.

### [Embodiments]

### <Overall System Configuration>

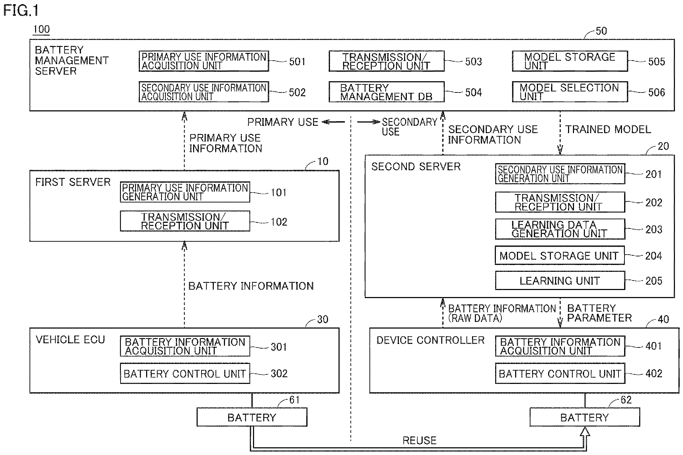

Fig. 1 is a block diagram illustrating an example of an overall configuration of a battery management system according to an embodiment of the present disclosure. The battery management system 100 includes a first server 10, a second server 20, a vehicle ECU (Electronic Control Unit) 30, a device controller 40, and a battery management server 50.

In the present embodiment, as one exemplary embodiment, it is assumed that a battery is used for a vehicle in primary use, while the battery is used for a stationary use in secondary use. That is, a battery 61 mounted on a vehicle is reused as a battery 62 of a stationary power supply system. However, the applications of the batteries 61 and 62 are not particularly limited. The applications may be opposite to those in this example. Alternatively, both primary use and secondary use applications may be those for the vehicle, or both primary use and secondary use applications may be those for the stationary use.

Each of the batteries 61 and 62 is a battery assembly including a plurality of secondary batteries. The types of the batteries 61 and 62 are not particularly limited. The batteries 61 and 62 may be, for example, lithium ion batteries, nickel-metal hydride batteries, or all-solid-state batteries. Each of the batteries 61 and 62 is assigned an identification number (hereinafter, it is referred to as "battery ID") unique to the battery.

The first server 10 is a server for managing primary use of the battery 61. The first server 10 is managed and operated by, for example, a manufacturer of the vehicle. The first server 10 includes a primary use information generation unit 101 and a transmission/reception unit 102.

The primary use information generation unit 101 generates primary use information indicating a manner of use of the battery 61 during primary use of the battery 61. The transmission/reception unit 102 is configured to transmit and receive information to and from external devices (such as the vehicle ECU 30 and the battery management server 50). The primary use information generation unit 101 acquires battery information (such as data measured by various sensors mounted on the vehicle) from the vehicle ECU 30, and generates primary use information based on the acquired battery information. The primary use information includes a use history of the battery 61 during primary use. The primary use information may include, for example, a temperature history (such as a temporal change or a frequency distribution of the temperature) of the battery 61 during primary use (both during charging and discharging and during a pause). The primary use information may include a charging and discharging history (such as a temporal change or a frequency distribution of a voltage and/or a current) of the battery 61 during primary use (during charging and discharging). The primary use information may include the number of times the battery 61 has been charged and discharged during primary use, and may include a start time and/or an end time of charging/discharging of the battery 61 during primary use. The primary use information may include an amount of change in shape (expansion amount or the like) of the battery 61. The primary use information generation unit 101 transmits the primary use information to the battery management server 50 via the transmission/reception unit 102.

The second server 20 is a server for managing secondary use of the battery 62. For example, the second server 20 may be managed and operated by a manufacturer of the vehicle or may be managed and operated by an administrator of the stationary power supply system. The second server 20 includes a secondary use information generation unit 201, a transmission/reception unit 202, a learning data generation unit 203, a model storage unit 204, and a learning unit 205.

The secondary use information generation unit 201 generates secondary use information indicating a manner of use of the battery 62 during secondary use of the battery 62. The transmission/reception unit 202 is configured to transmit and receive information to and from external devices (such as the device controller 40 and the battery management server 50). The secondary use information generation unit 201 acquires battery information (data measured by various sensors arranged in the stationary power supply system) from the device controller 40, and generates secondary use information based on the acquired battery information. Similarly to the primary use information, the secondary use information may include a temperature history, a charging and discharging history, the number of times the battery 62 has been charged and discharged, a start time and/or an end time of charging/discharging, an amount of change in shape, and the like, of the battery 62 during secondary use. The secondary use information generation unit 201 transmits the secondary use information to the battery management server 50 via the transmission/reception unit 202.

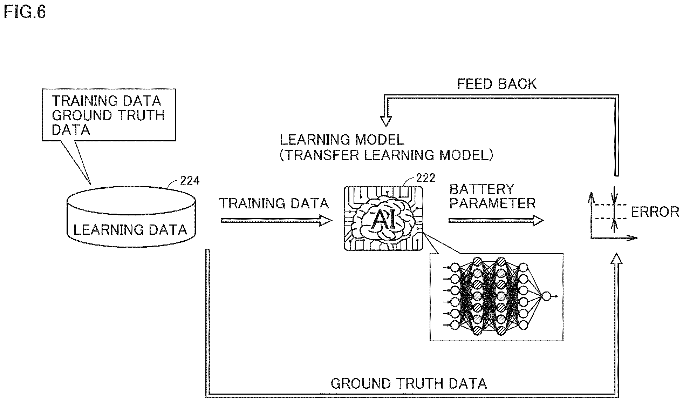

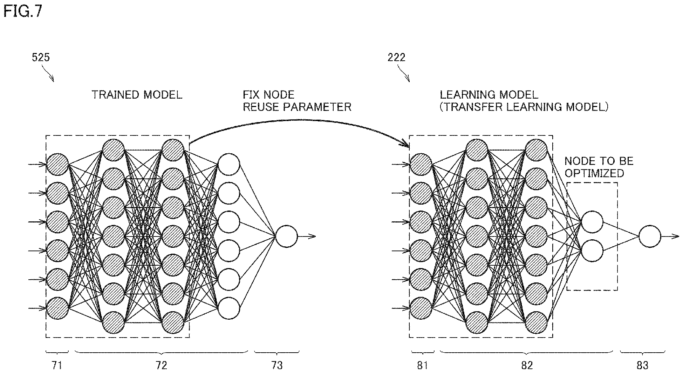

The learning data generation unit 203 generates learning data for use in learning of the second learning model based on raw data (data dependent on the use history of the battery 62 measured by various sensors provided in the stationary power supply system) collected from the stationary power supply system (preferably, a large number of systems incorporating batteries of the same type). The model storage unit 204 stores the trained model provided from the battery management server 50. The learning unit 205 updates the trained model by performing machine learning on the trained model using the learning data (see Figs. 6 and 7 described later).

The vehicle ECU 30 controls a vehicle (not shown) on which the battery 61 that is used in the primary use is mounted. The vehicle ECU 30 includes a battery information acquisition unit 301 and a battery control unit 302.

The battery information acquisition unit 301 acquires battery information regarding the battery 61 during primary use. As described above, the battery information includes data (such as temperature, voltage, and/or current changes over time) measured by various sensors mounted on the vehicle. The battery control unit 302 controls charging and discharging of the battery 61 according to the battery information. The vehicle ECU 30 transmits the battery information acquired from the vehicle to the first server 10 via a data communication module (DCM) (not shown).

The device controller 40 controls a stationary power supply system in which the battery 62 for secondary use (reuse of the battery 61 for primary use) is disposed. The device controller 40 includes a battery information acquisition unit 401 and a battery control unit 402.

The battery information acquisition unit 401 acquires battery information regarding the battery 62 during secondary use. The battery information includes data (raw data indicating temporal changes in temperature, voltage, and/or current) measured by various sensors provided in the stationary power supply system. The battery control unit 402 controls charging and discharging of the battery 62 according to the battery information. The device controller 40 transmits the battery information acquired from the stationary power supply system to the second server 20.

The battery management server 50 manages batteries for both primary use and secondary use. The battery management server 50 includes a primary use information acquisition unit 501, a secondary use information acquisition unit 502, a transmission/reception unit 503, a battery management database 504, a model storage unit 505, and a model selection unit 506.

The primary use information acquisition unit 501 acquires primary use information from the first server 10. The secondary use information acquisition unit 502 acquires secondary use information from the second server 20. The transmission/reception unit 503 is configured to transmit and receive information (primary use information, secondary use information, and the like) to and from external devices (the first server 10, the second server 20, and the like). The battery management database 504 stores various pieces of information (such as a use pattern map described later) for managing the batteries 61 and 62 in association with the battery IDs.

The model storage unit 505 stores a plurality of trained models for estimating various battery parameters relating to the battery 61 during secondary use. The battery parameter is a parameter indicating a state of the battery 62, and typically includes a state of charge (SOC) of the battery 62. The battery parameters may include a state of health (SOH) (full charge capacity, capacity retention ratio, etc.) of the battery 62. However, the battery parameter is not limited thereto, and may include a self-discharge amount of the battery 62, and may include a value indicating an abnormality of the battery 62 (such as excessive expansion of the electrode assembly, short circuit in the electrode assembly, or leakage of an electrolyte solution).

The model selection unit 506 selects any trained model from among the plurality of trained models based on the primary use information and the secondary use information. The model selection unit 506 provides the selected trained model to the second server 20.

### <Configuration of Each Device>

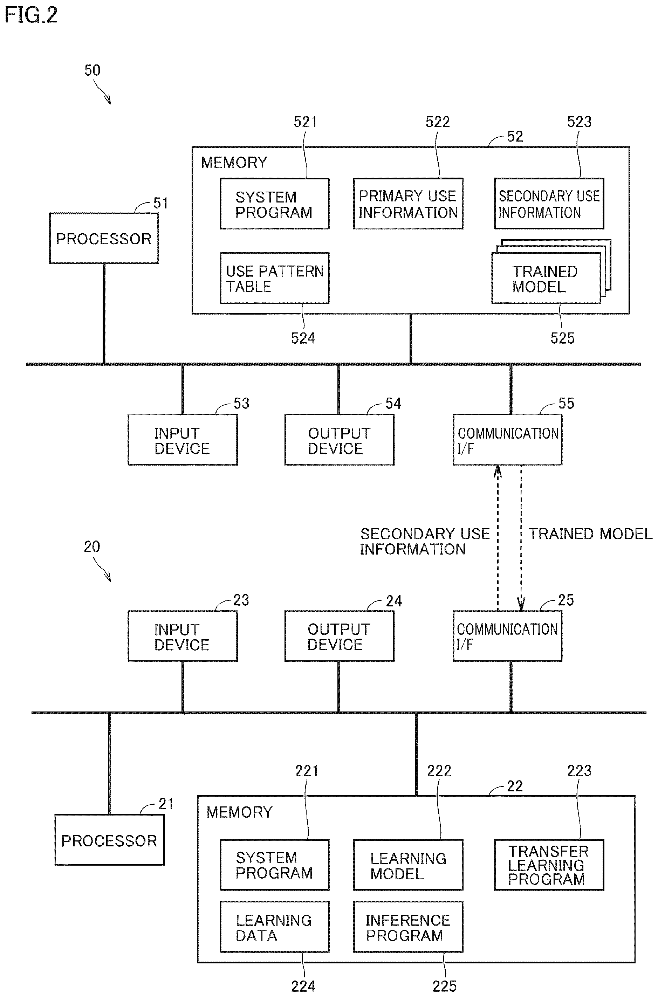

Fig. 2 is a block diagram showing an example of the configurations of the battery management server 50 and the second server 20. The battery management server 50 includes, for example, a processor 51, a memory 52, an input device 53, an output device 54, and a communication interface 55.

The processor 51 is an arithmetic processing device such as central processing unit (CPU) or micro processing unit (MPU). The processor 51 implements various arithmetic processing by reading a program, a parameter, a map, a learning model, and the like stored in the memory 52 and deploying them in the memory 52. Note that, in the present specification, the "processor" is not limited to a processor in a narrow sense that executes processing by a stored program method, and may include a hardwired circuit such as ASIC (Application Specific Integrated Circuit), FPGA (Field-Programmable Gate Array). As such, the term "processor" may also be read to refer to processing circuitry in which processing is predefined by computer readable code and/or hardwired circuitry.

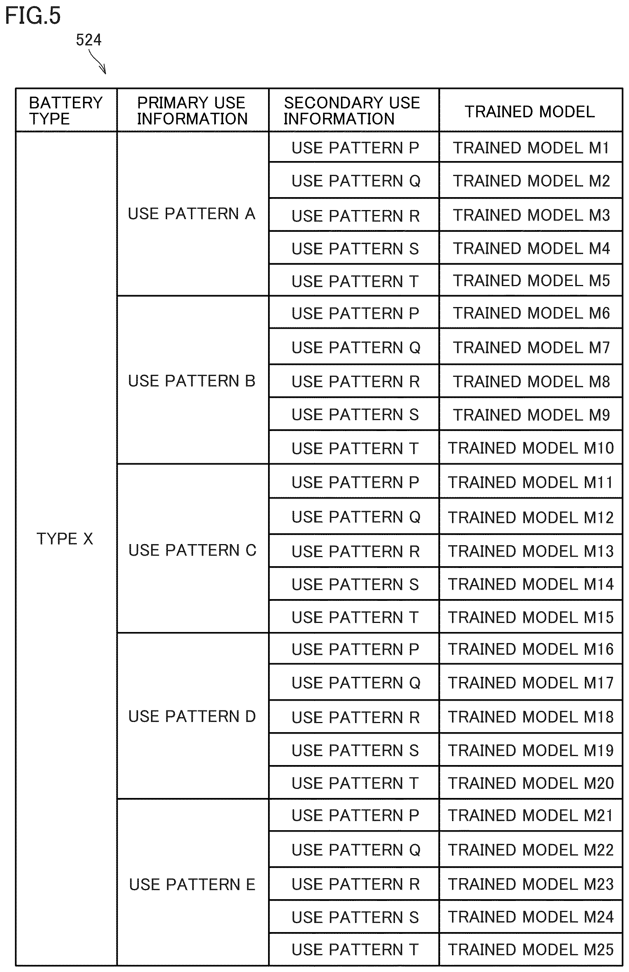

The memory 52 includes, for example, a volatile storage device such as DRAM (Dynamic Random Access Memory) or SRAM (Static Random Access Memory), and a nonvolatile storage device such as HDD (Hard Disk Drive), SSD (Solid State Drive), or flash memory. The memory 52 stores a system program 521 including an OS (Operating System), primary use information 522, secondary use information 523, a use pattern table 524 (see Fig. 5 to be described later) in which the manners of use of a battery are classified into patterns, and a plurality of trained models 525 each trained to estimate a battery parameter from a use history of the battery.

The input device 53 is a keyboard, a mouse, a touch panel, an operation button, or the like, and is configured to receive an operation by a user of the battery management server 50 (a person in charge of a battery reuse provider, or the like). The output device 54 is a monitor, a printer, or the like, and is configured to output the progress and the result of the arithmetic processing by the processor 51. The communication interface 55 is configured to transmit and receive information to and from the outside via the transmission/reception unit 503 (see Fig. 1).

The second server 20 includes, for example, a processor 21, a memory 22, an input device 23, an output device 24, and a communication interface 25.

The processor 21 is an arithmetic processing device similar to the processor 51. Like the memory 52, the memory 22 includes a volatile storage device and a nonvolatile storage device. The processor 21 implements various arithmetic processing by reading a program or the like stored in the memory 22 and deploying the program or the like in the memory 22. The memory 22 stores a system program 221, a trained model (learning model) 222 provided from the battery management server 50, a transfer learning program 223 for further causing the learning model 222 to be subjected to learning (specifically, transfer learning), a group of learning data 224 used for learning (in this example, supervised machine learning) of the learning model 222, and an inference program 225 for executing inference (estimation of battery parameters) using the learning model 222.

The input device 23, the output device 24, and the communication interface 25 are equivalent to the corresponding devices of the battery management server 50.

### <Use Patterns>

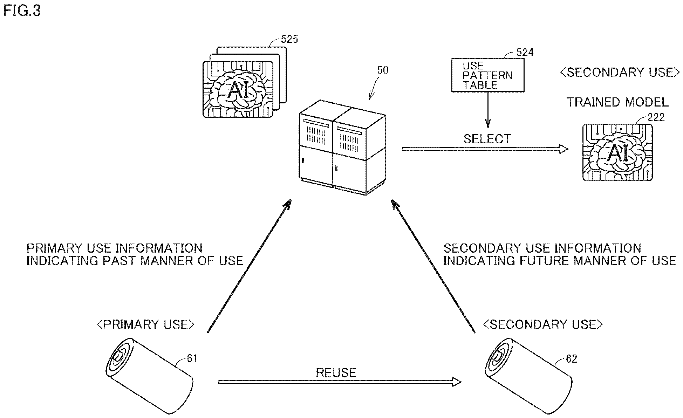

Fig. 3 is a conceptual diagram for explaining selection of a trained model in the present embodiment. Referring to Figs. 1 to 3, in the present embodiment, battery management server 50 selects any model from among a plurality of trained models 525 prepared in advance, based on primary use information indicating a past manner of use of battery 61 and secondary use information indicating a future manner of use of battery 62, and provides the model to second server 20 as learning model 222. In this example, a plurality of use patterns are defined according to the primary use information and the secondary use information. The plurality of use patterns are organized as a use pattern table 524.

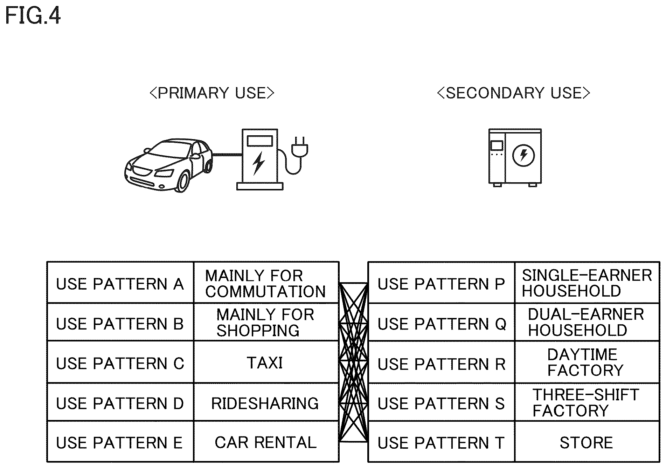

Fig. 4 is a diagram for explaining an example of classification of use patterns. In the example shown in Fig. 4, the manner of use of the battery 61 during primary use is classified into any of the five use patterns A to E based on the primary use information. The use patterns A to E are, for example, patterns indicating a manner of use of the battery 61 mounted on the vehicle. The use pattern A is a pattern of use mainly for commutation, the use pattern B is a pattern of use mainly for shopping, the use pattern C is a pattern for taxi, the use pattern D is a pattern for ridesharing, and the use pattern E is a pattern for car rental.

Similarly, the manner of use of the battery 62 during secondary use is classified into any of the five use patterns P to T based on the secondary use information. The use patterns P to T are, for example, patterns indicating a manner of use of the battery 62 that is a stationary battery. The use pattern P is a pattern for a single-earner household, the use pattern Q is a pattern for a dual-earner household, the use pattern R is a pattern for a daytime factory, the use pattern S is a pattern for a three-shift factory, and the use pattern T is a pattern for a store.

In this example, the manner of use of the battery during primary use and during secondary use is classified into any of a total of 25 use patterns obtained by combining five use patterns A to E and five use patterns P to T.

Fig. 5 is a diagram illustrating the use pattern table 524. In the use pattern table 524, for example, a battery type (typically, a model number), primary use information (for example, use patterns A to E), secondary use information (for example, use patterns P to T), and trained models (trained models M1 to M25) are associated with each other. As described above, the battery management server 50 (model storage unit 505) may store each of the plurality of trained models 525 in association with the primary use information and the secondary use information. The battery management server 50 selects any one trained model based on the battery type, the primary use information, and the secondary use information by referring to the use pattern table 524. The trained model selected by the battery management server 50 is provided to the second server 20, and subjected to transfer learning performed by the second server 20.

### <Machine Learning Model>

Fig. 6 is a diagram for explaining an example of transfer learning by the second server 20. Referring to Figs. 1, 2, and 6, the trained model 525 (i.e., the learning model 222) for which transfer learning is performed is, for example, a neural network model. Techniques such as convolutional neural network (CNN), residual neural network (ResNet), generative adversarial network (GAN), stacked autoencoder, and transformer may be used to generate the learning model 222.

The second server 20 (learning unit 205) trains the learning model 222 using the learning data 224. More specifically, in this example, the learning data 224 includes training data and ground truth data (ground truth label). The second server 20 inputs the training data to the learning model 222, and acquires an inference result (estimation result of the battery parameter) from the learning model 222. The second server 20 trains the learning model 222 by feeding back an error between the ground truth data and the estimation result of the battery parameter (error backpropagation).

Fig. 7 is a diagram for explaining a specific example of transfer learning. In the figure, a trained model 525 is shown on the left side, and a learning model 222 for which transfer learning is performed by reusing a part of the trained model 525 is shown on the right side.

The trained model 525 includes an input layer 71, one or more intermediate layers (hidden layers) 72, and an output layer 73. Similarly, the learning model 222 includes an input layer 81 that receives training data, one or more intermediate layers (hidden layers) 82, and an output layer 83 that outputs estimation results of battery parameters.

In this example, the input layer 71 of the trained model 525 and a part of the one or more intermediate layers 72 (for example, only the last layer of the intermediate layers) are directly reused as the input layer 81 of the learning model 222 and a part of the one or more intermediate layers 82. That is, in these layers, since the nodes are fixed and the parameters (weight, bias, etc.) are reused, a part of the neural network is common. On the other hand, the rest of the one or more intermediate layers 82 of the learning model 222 is newly trained using the learning data 224 (see Fig. 2). As a result, a parameter corresponding to a node specified in advance is optimized.

In the example illustrated in Fig. 7, the number of the intermediate layers is equal between the trained model 525 and the learning model 222. However, the number of the intermediate layers may be different from each other. For example, a new intermediate layer may be added to the learning model 222, and training may be newly performed on the added intermediate layer. Further, in this example, a part of the intermediate layers on the side close to the input layer is reused. However, the intermediate layers that can be reused are not limited to those on the side close to the input layer.

As described above, by performing the transfer learning, the number of the intermediate layer to be trained is reduced (in particular, fewer parameters are optimized in the backpropagation) as compared with a case where the learning model 222 is newly trained, and thus training with a smaller amount of learning data 224 is possible. For example, when only the last layer of the intermediate layers is trained, the inverse recurrence equation of backpropagation may be calculated only once. Therefore, the amount of calculation required for training the learning model 222 can be reduced, and the time required for machine learning can be reduced. As a result, a highly accurate trained model optimized for secondary use of the battery 62 can be generated in a short time.

### <Process Flow>

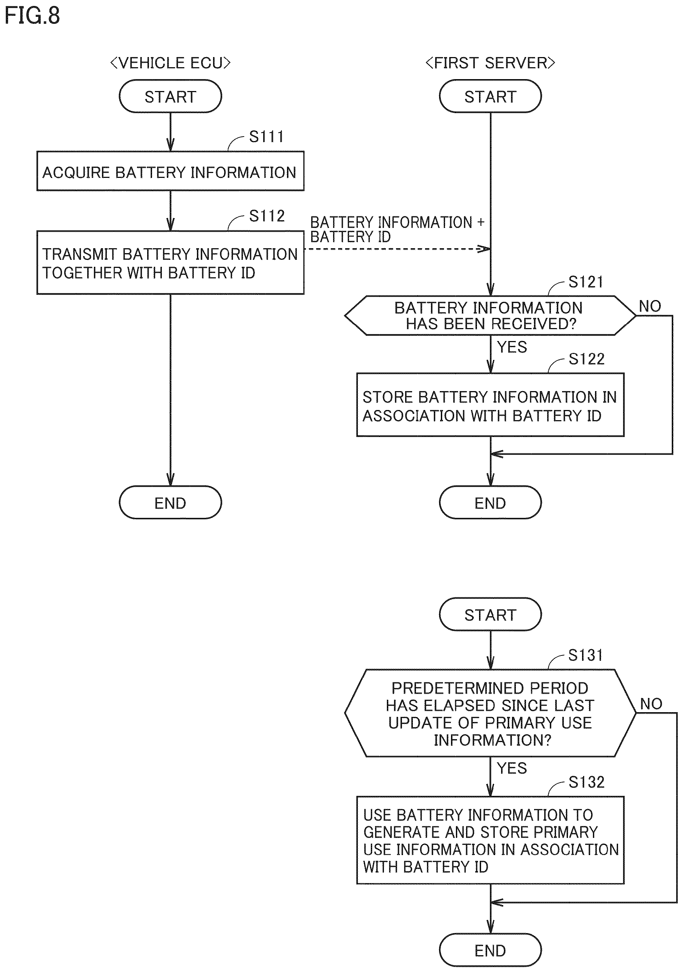

Fig. 8 is a flowchart showing an example of a processing procedure relating to acquisition of battery information and generation of primary use information during primary use of the battery 61. The process shown in this flowchart is executed when a predetermined condition is satisfied (for example, every predetermined cycle). Each step is typically realized by software processing by the vehicle ECU 30 or the first server 10, but may be realized by hardware (electrical circuit). Hereinafter, the step is abbreviated as S. The same applies to other flowcharts described later.

Referring to Figs. 1 and 8, in S111, the vehicle ECU 30 acquires battery information (such as raw data measured by various sensors) of the battery 61 during primary use. The vehicle ECU 30 transmits the acquired battery information together with the battery ID of the battery 61 to the first server 10 (S112).

In S121, the first server 10 determines whether battery information of the battery 61 has been acquired from the vehicle ECU 30. When the battery information has been acquired (YES in S121), the vehicle ECU 30 stores the battery information in the memory in association with the battery ID (S122).

In S131, the first server 10 determines whether a predetermined period has elapsed since the last update of the primary use information. When the predetermined period has elapsed (YES in S131), the first server 10 generates the primary use information of the battery 61 (a temperature history, a charging and discharging history, the number of times the battery has been charged and discharged, a start time and/or an end time of charging/discharging, an amount of change in shape, and the like, of the battery 61 during primary use) using the battery information of the battery 61. Then, the first server 10 stores the primary use information in the memory in association with the battery ID (S132).

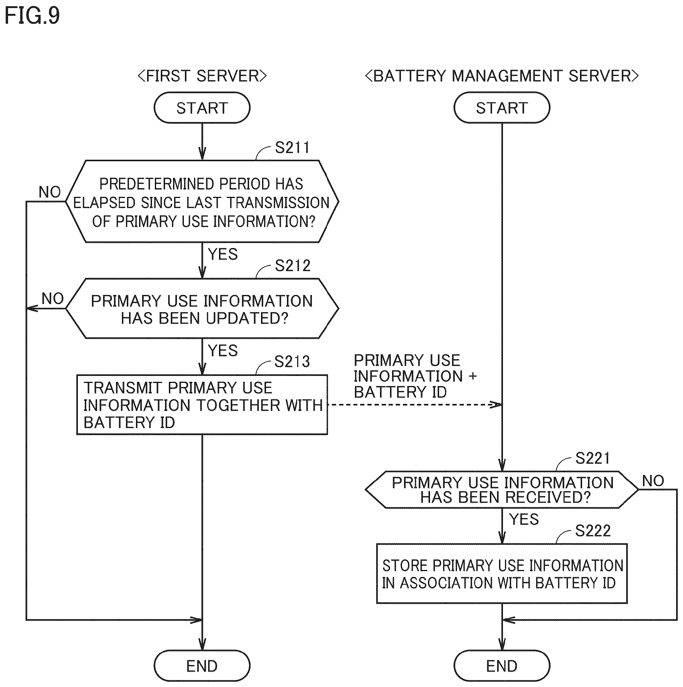

Fig. 9 is a flowchart illustrating an example of a processing procedure relating to transmission and reception of primary use information. Referring to Fig. 1, Fig. 2, and Fig. 9, in S211, the first server 10 determines whether or not a predetermined period of time has elapsed since the last transmission of the primary use information of the battery 61. When the predetermined period has elapsed (YES in S211), the first server 10 determines whether the current primary use information has been updated from the previous primary use information (S212). When the primary use information has been updated (YES in S212), the first server 10 transmits the current primary use information together with the battery ID to the battery management server 50 (S213).

In S221, the battery management server 50 determines whether the primary use information of the battery 61 has been received from the first server 10. When the primary use information has been received (YES in S222), the battery management server 50 stores the primary use information in the memory 52 (battery management database 504) in association with the battery ID.

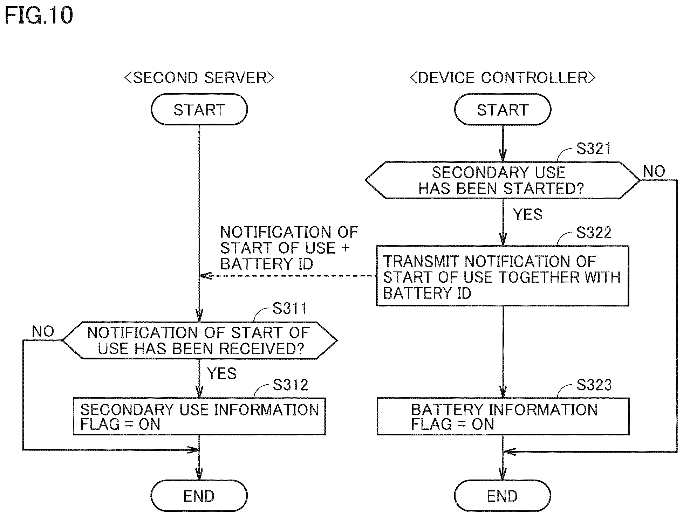

Fig. 10 is a flowchart illustrating an example of a processing procedure relating to the start of secondary use of the battery 62. Referring to Figs. 1, 2, and 10, in S321, the device controller 40 determines whether secondary use of the battery 62 has been started. When the secondary use of the battery 62 has been started (YES in S321), the device controller 40 transmits a notification (notification of start of use) indicating that the secondary use of the battery 62 is started to the second server 20 together with the battery ID (S322). Then, the device controller 40 sets the battery information flag to ON (S323).

In S311, the second server 20 determines whether the notification of start of use has been received from the device controller 40. When the notification of start of use has been received (YES in S311), the second server 20 sets the secondary use information flag to ON (S312).

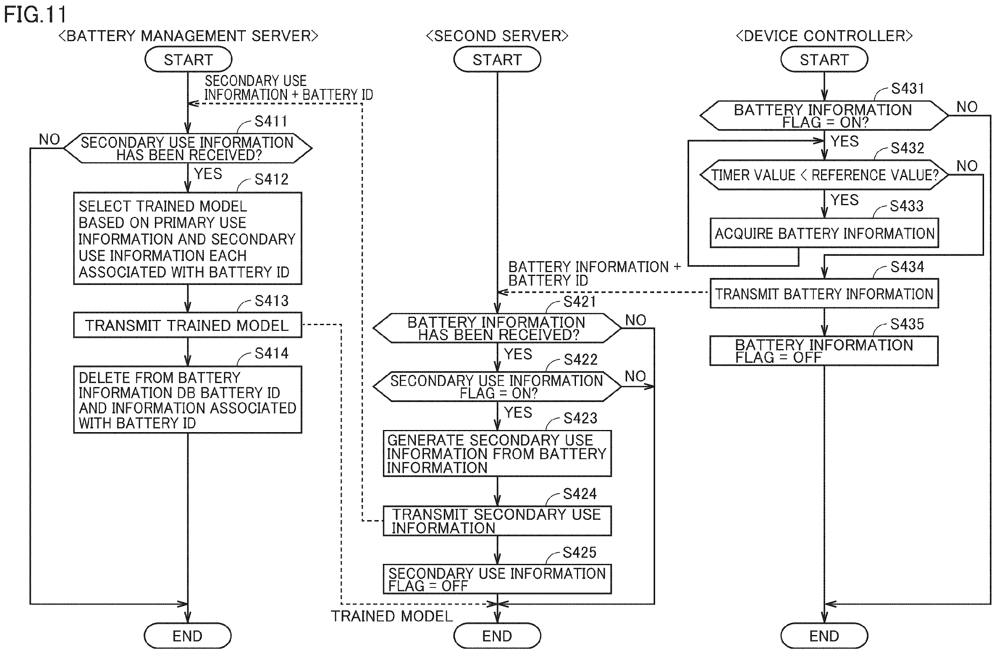

Fig. 11 is a flowchart illustrating an example of a processing procedure relating to selection of the trained model 525. Referring to Figs. 1, 2, and 11, in S431, the device controller 40 determines whether or not the battery information flag is ON. When the battery information flag is ON (YES in S431), the device controller 40 determines whether a timer value indicating an elapsed time from the start of secondary use is less than a reference value (S432). When the timer value is less than the reference value (YES in S432), the device controller 40 acquires battery information (raw data measured by various sensors, or the like) of the battery 62 (S433). When the timer value becomes equal to or larger than the reference value (NO in S432), the device controller 40 transmits the battery information together with the battery ID to the second server 20 (S434). Then, the device controller 40 returns the battery information flag from ON to OFF (S435).

In S434, instead of receiving the battery information from the device controller 40, the second server 20 may acquire information based on the operation of the administrator of the battery 62. More specifically, the administrator of the battery 62 may perform an operation (e.g., a response to a questionnaire) of selecting which use pattern (such as the use patterns P to T in Fig. 4) the secondary use of the battery 62 corresponds to, and the second server 20 may acquire the use pattern in accordance with the operation.

In S421, the second server 20 determines whether battery information has been received from the device controller 40. When the battery information has been received (YES in S421), the second server 20 determines whether or not the secondary use information flag is ON (S422). When the secondary use information flag is ON (YES in S422), the second server 20 generates secondary use information of the battery 62 (a temperature history, a charging and discharging history, the number of times the battery has been charged and discharged, a start time and/or an end time of charging/discharging, an amount of change in shape, and the like, of the battery 62 during secondary use) using the battery information of the battery 62 (S423). The second server 20 transmits the secondary use information together with the battery ID to the battery management server 50 (S424). Then, the second server 20 returns the secondary use information flag from ON to OFF (S425).

In S411, the battery management server 50 determines whether the secondary use information has been received from the second server 20. When the secondary use information has been received (YES in S411), the battery management server 50 selects any one trained model from among the plurality of trained models 525 based on the primary use information and the secondary use information each associated with the battery ID (S412). Since the selection method has been described in detail with reference to Figs. 4 and 5, the description thereof will not be repeated here. The battery management server 50 transmits the selected trained model to the second server 20 (S413). Then, the battery management server 50 deletes the battery IDs of the target batteries 61 and 62 and the information (primary use information and secondary use information) associated with the battery IDs from the battery management database 504 (S414).

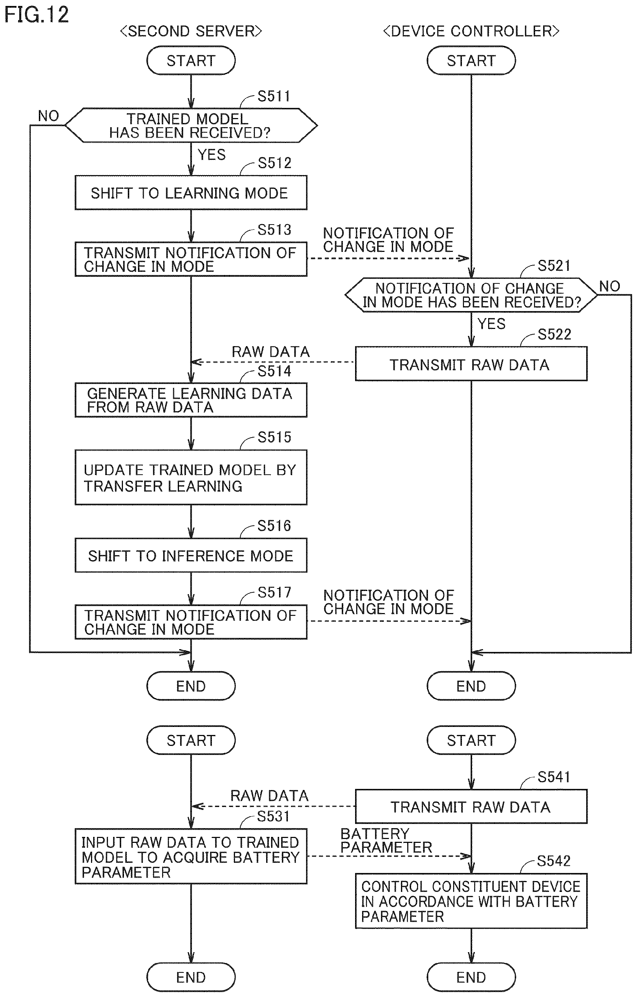

Fig. 12 is a flowchart illustrating an example of a processing procedure relating to transfer learning of the trained model 525 and inference using the learning model 222. Referring to Figs. 1, 2, and 12, in S511, the second server 20 determines whether the trained model 525 has been received from the battery management server 50. When the trained model 525 has been received (YES in S511), the second server 20 shifts to the learning mode (S512), and transmits a notification of change in mode to the device controller 40 (S513).

When the notification of change in mode has been received from the second server 20 (YES in S521), the device controller 40 transmits battery information (raw data of various sensors) of the battery 62 to the second server 20 (S522).

The second server 20 generates learning data 224 dependent on the use history of the battery 62 from the raw data (S514). The second server 20 may generate training data and ground truth data from the raw data and perform data expansion. Further, the second server 20 updates the trained model 525 (learning model 222) by performing transfer learning of the trained model 525 using the learning data 224 (S515). Thereafter, the second server 20 shifts from the learning mode to the inference mode (S516), and transmits a notification of change in mode to the device controller 40 (S517).

In the inference mode, the device controller 40 transmits battery information (raw data) of the battery 62 to the second server 20 (S541). The second server 20 acquires the estimation result of the battery parameter by inputting the raw data to the learning model 222 obtained by the transfer learning. The second server 20 transmits the battery parameter to the device controller 40 (S531). The device controller 40 controls the constituent devices of the stationary power supply system in accordance with the battery parameter (S542). As one specific example, the device controller 40 controls the converter and/or the inverter connected to the battery 62 so as to suppress the charge/discharge power of the battery 62 as compared to the previous case. The device controller 40 may control the display to display the acquired battery parameters.

### <Conclusion>

As described above, in the present embodiment, the battery management server 50 acquires the primary use information indicating a manner of use of the battery 61 during primary use (in the past) of the battery 61 and the secondary use information indicating a manner of use of the battery 62 during secondary use (in the future) of the battery 62. The battery management server 50 selects a model for estimating a battery parameter during secondary use, from among a plurality of trained models 525 trained to estimate the battery parameter during primary use, based on the primary use information and the secondary use information.

It is also conceivable to newly generate a learning model for estimating the battery parameter during secondary use. However, since this requires a large amount of learning data, it takes time to prepare required learning data. In the present embodiment, since any one of the plurality of trained models 525 is selected, the learning model 222 for estimating the battery parameter during secondary use can be provided at an early stage.

In addition, the amount of data of the learning data 224 required to generate the learning model 222 can be reduced because the transfer learning of the selected model can selectively train a model architecture (a specific intermediate layer) for identifying a specific feature. Therefore, even in the case where or at the time when the amount of learning data (learning data 224) necessary for training of the learning model 222 (training in a case where transfer learning is not performed) cannot be prepared during secondary use of the battery 62, the learning model 222 can be generated. Therefore, according to the present embodiment, it is possible to smoothly generate the learning model 222 used for the secondary use of the battery 62.

### [Modifications]

The first server 10 and the vehicle ECU 30 may be integrated. That is, the function of the first server 10 may be incorporated in the vehicle ECU 30. Similarly, the second server 20 and the device controller 40 may be integrated, and the function of the second server 20 may be incorporated in the device controller 40.

In Fig. 1, the second server 20 includes the learning model 222, and the device controller 40 acquires the estimation result of the battery parameter from the second server 20. In other words, the second server 20 and the device controller 40 have a cloud system configuration. Alternatively, the device controller 40 may include the learning model 222, and the device controller 40 itself may acquire the battery parameters from the learning model 222. That is, an edge-type system configuration can also be employed.

In the system configuration illustrated in Fig. 1, the second server 20 includes the learning unit 205. Alternatively, the battery management server 50 may include the learning unit, or the device controller 40 may include the learning unit.

In Fig. 11, the second server 20 may be capable of receiving (downloading) the trained model 525 from the battery management server 50 in accordance with a request (operation by the administrator of the battery 62) from the second server 20 to the battery management server 50. For example, when the battery 61 mounted on the vehicle is reused as the battery 62 of the stationary power supply system, the administrator of the battery 62 may perform the operation.

The battery information may be collected from another device (for example, an administrator terminal of the batteries 61 and 62) instead of the vehicle ECU 30 and the device controller 40. As one example, the start time or the end time of charging and discharging of the batteries 61 and 62 can be extracted from the schedule information of the administrator terminal.

Hereinafter, in the system configuration illustrated in Fig. 1, it is assumed that the battery management server 50 includes the learning unit, instead of the second server 20. However, the device including the learning unit is not particularly limited.

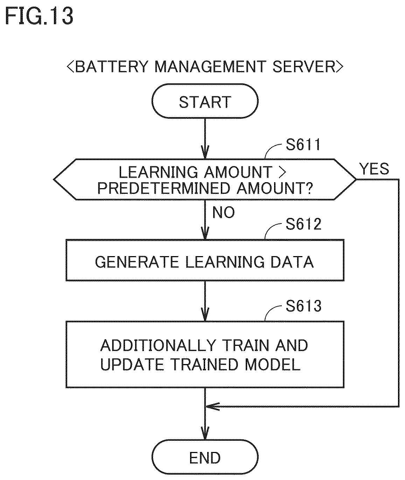

Fig. 13 is a flowchart illustrating an example of a processing procedure for the trained model 525 according to a modification. In S611, the battery management server 50 determines, for example, whether the learning amount of the trained model 525 provided to the second server 20 has reached a predetermined amount. Whether or not the learning amount has reached the predetermined amount can be determined based on, for example, the amount of learning data used in the past when training the trained model 525. When the learning amount has not reached the predetermined amount (NO in S611), the battery management server 50 generates learning data from the raw data acquired from the second server 20 (S612). Then, the battery management server 50 further trains the trained model 525 using the learning data (S613). As a result, the trained model 525 of the battery management server 50 is updated.

As described above, the battery management server 50 may perform additional learning using the learning data acquired during secondary use for the trained model for which the learning amount has not reached the predetermined amount and the estimation accuracy of the battery parameter is relatively low. As a result, the estimation accuracy of the battery parameter by the trained model can be improved.

### [Clauses]

It will be understood by those skilled in the art that the exemplary embodiments described above are specific examples of the following aspects.

### <Clause 1>

A battery management system including:
a primary use information acquisition unit that acquires primary use information indicating a manner of use of a battery during primary use of the battery;
a secondary use information acquisition unit that acquires secondary use information indicating a manner of use of the battery during secondary use of the battery; and
a model selection unit that selects, from among a plurality of trained models trained to estimate a battery parameter indicating a state of the battery during the primary use, a trained model for estimating the battery parameter during the secondary use, based on the primary use information and the secondary use information.

### <Clause 2>

The battery management system according to Clause 1, further including: a learning unit that updates the trained model selected by the model selection unit, by inputting learning data dependent on a use history of the battery during the secondary use, to a transfer learning model to which a part of the trained model selected by the model selection unit is reused.

### <Clause 3>

The battery management system according to Clause 1 or 2, further including a model storage unit that stores each of the plurality of trained models in association with the primary use information and the secondary use information.

### <Clause 4>

The battery management system according to Clause 1, further including a learning unit that generates the plurality of trained models so as to estimate the battery parameters from a use history of the battery during the secondary use, wherein
the learning unit determines whether or not a learning amount has reached a predetermined amount for any of the plurality of trained models, and further trains a model for which the learning amount has not reached the predetermined amount, using learning data indicating the use history of the battery during the secondary use.

### <Clause 5>

The battery management system according to any one of Clauses 1 to 4, wherein the battery parameter includes a value indicating at least one of a state of charge, a state of health, a self-discharge amount, and an abnormality of the battery.

### <Clause 6>

The battery management system according to any one of Clauses 1 to 5, wherein
the primary use information includes data indicating at least one of a temperature history, a charging and discharging history, the number of times charging and discharging are performed, a start time or an end time of charging and discharging, and an amount of change in shape, of the battery during the primary use, and
the secondary use information includes data indicating at least one of a temperature history, a charging and discharging history, the number of times charging and discharging are performed, a start time or an end time of charging and discharging, and an amount of change in shape, of the battery during the secondary use.

### <Clause 7>

A battery management method including:
acquiring primary use information indicating a manner of use of a battery during primary use of the battery;
acquiring secondary use information indicating a manner of use of the battery during secondary use of the battery; and
selecting, from among a plurality of trained models trained to estimate a battery parameter indicating a state of the battery during the primary use, a trained model for estimating the battery parameter during the secondary use, based on the primary use information and the secondary use information.

Although the present disclosure has been described and illustrated in detail, it is clearly understood that the same is by way of illustration and example only and is not to be taken by way of limitation, the scope of the present disclosure being interpreted by the terms of the appended claims.

## Claims

1. A battery management system (100) comprising:
a primary use information acquisition unit (501) that acquires primary use information indicating a manner of use of a battery (61, 62) during primary use of the battery (61, 62);
a secondary use information acquisition unit (502) that acquires secondary use information indicating a manner of use of the battery (61, 62) during secondary use of the battery (61, 62); and
a model selection unit (506) that selects, from among a plurality of trained models (525) trained to estimate a battery parameter indicating a state of the battery (61, 62) during the primary use, a trained model for estimating the battery parameter during the secondary use, based on the primary use information and the secondary use information.

2. The battery management system (100) according to claim 1, further comprising a learning unit (205) that updates the trained model selected by the model selection unit, by inputting learning data dependent on a use history of the battery (61, 62) during the secondary use, to a transfer learning model to which a part of the trained model selected by the model selection unit is reused.

3. The battery management system (100) according to claim 1 or 2, further comprising a model storage unit (204) that stores each of the plurality of trained models (525) in association with the primary use information and the secondary use information.

4. The battery management system (100) according to claim 1, further comprising a learning unit (205) that generates the plurality of trained models (525) so as to estimate the battery parameter from a use history of the battery (61, 62) during the secondary use, wherein
the learning unit (205) determines whether or not a learning amount has reached a predetermined amount for any of the plurality of trained models, and further trains a model for which the learning amount has not reached the predetermined amount, using learning data indicating the use history of the battery (61, 62) during the secondary use.

5. The battery management system (100) according to any one of claims 1 to 4, wherein the battery parameter includes a value indicating at least one of a state of charge, a state of health, a self-discharge amount, and an abnormality of the battery (61, 62).

6. The battery management system (100) according to any one of claims 1 to 5, wherein
the primary use information includes data indicating at least one of a temperature history, a charging and discharging history, the number of times charging and discharging are performed, a start time or an end time of charging and discharging, and an amount of change in shape, of the battery (61, 62) during the primary use, and
the secondary use information includes data indicating at least one of a temperature history, a charging and discharging history, the number of times charging and discharging are performed, a start time or an end time of charging and discharging, and an amount of change in shape, of the battery (61, 62) during the secondary use.

7. A battery management method comprising:
acquiring primary use information indicating a manner of use of a battery (61, 62) during primary use of the battery (61, 62);
acquiring secondary use information indicating a manner of use of the battery (61, 62) during secondary use of the battery (61, 62); and
selecting, from among a plurality of trained models (525) trained to estimate a battery parameter indicating a state of the battery (61, 62) during the primary use, a trained model for estimating the battery parameter during the secondary use, based on the primary use information and the secondary use information.

8. A data structure for managing a battery (61, 62), wherein
the data structure is used for a process of selecting, from among a plurality of trained models (525) trained to estimate a battery parameter indicating a state of a battery (61, 62) during primary use of the battery (61, 62), a trained model for estimating the battery parameter during secondary use of the battery (61, 62), and
a type of the battery (61, 62), primary use information indicating a manner of use of the battery (61, 62) during the primary use, secondary use information indicating a manner of use of the battery (61, 62) during the secondary use, and a trained model among the plurality of trained models (525) are associated with each other.
